# EUROPEAN PATENT APPLICATION

(11) **EP 4 848 914 A2**
(43) Date of publication of application: **02.12.2026**
(21) Application number: 26193628.0
(22) Date of filing: 04.03.2025
(51) Int. Cl.: H05K 5/06

(54) **POWER MODULE AND CHARGING DEVICE**

(30) Priority: 05.03.2024 CN 202420425277 U
(62) Document number(s) of the earlier application(s) in accordance with Art. 76 EPC: 25161475.6 / 4 615 182
(71) Applicant: Huawei Digital Power Technologies Co., Ltd., Shenzhen, Guangdong 518043 (CN)
(72) Inventor: LIU, Yaping, Shenzhen, 518043 (CN); XIONG, Yongsheng, Shenzhen, 518043 (CN)
(74) Representative: Epping - Hermann - Fischer

(57) **Abstract**

Embodiments of this application provide a power module and a charging device. The power module includes a circuit board, a power component, a heat conductor, and a liquid cooling component, where the power component is located between the circuit board and the liquid cooling component. The power component includes a power component body and a pin, and the power component body is fastened to a surface of the circuit board via the pin. In addition, the power component body is in heat-conducting connection to the liquid cooling component, and the pin is connected to the liquid cooling component via the heat conductor. In this way, the liquid cooling component can not only exchange heat with the power component body, but also exchange heat with the pin via the heat conductor, to implement liquid-cooling heat dissipation for the power component body and the pin. Further, in embodiments of this application, overall heat dissipation effect of the power component can be improved, and a heat dissipation requirement of the power component during high-power operation can be met, so that the charging device can perform high-power charging on an electric vehicle.

## Description

### TECHNICAL FIELD

This application relates to the field of power component heat dissipation technologies, and more specifically, to a power module and a charging device.

### BACKGROUND

Currently, with acceleration of the dual carbon strategy and increasing popularity of electric vehicles, more cities are transforming into ultra-fast charging cities. This drives charging devices to develop into high-power ultra-fast charging devices, to quickly supplement energy for the electric vehicles at one kilometer per second, thereby creating brand-new charging experience of "charge up while you coffee up".

However, when a charging device performs high-power ultra-fast charging on the electric vehicle, a power component in the charging device generates a large amount of heat. If the heat cannot be discharged in time, normal high-power ultra-fast charging of the electric vehicle by the charging device is easily affected. Currently, an air-cooling heat dissipation manner is usually used to dissipate heat for the power component in the charging device. However, this heat dissipation manner has poor heat dissipation effect, and can hardly meet a heat dissipation requirement of the power component during high-power operation. As a result, reliability and a service life of the power component are affected.

### UTILITY MODEL CONTENT

This application provides a power module and a charging device, to improve heat dissipation effect of a power component in the power module, meet a heat dissipation requirement of the power component during high-power operation, and prolong a service life of the power module and improve reliability of the power module during high-power operation. This helps the charging device implement a charging speed of one kilometer per second, that is, supplement electric energy of one kilometer of driving range per second for an electric vehicle, thereby bringing charging experience of "charge up while you coffee up" to a user.

According to a first aspect, a power module is provided. The power module includes a circuit board, a power component, a heat conductor, and a liquid cooling component, where the power component is located between the circuit board and the liquid cooling component. The power component includes a power component body and a pin, and the power component body is fastened to a surface of the circuit board via the pin. The power component body is in heat-conducting connection to the liquid cooling component, and the pin is in heat-conducting connection to the liquid cooling component via the heat conductor. The liquid cooling component is configured to exchange heat with the power component body and the heat conductor.

In the power module provided in this embodiment of this application, a cooling medium in the liquid cooling component may not only exchange heat with the power component body, but also exchange heat with the pin via the heat conductor, to take away heat generated by the power component body and the pin, and implement liquid-cooling heat dissipation for the power component body and the pin. In addition, compared with air-cooling heat dissipation, liquid-cooling heat dissipation is more efficient. Further, this improves overall heat dissipation effect of the power component, and helps meet a heat dissipation requirement of the power component during high-power operation, and prolong a service life of the power module and improve reliability of the power module during high-power operation.

In this way, when the power module is used in a charging device, the charging device can implement a charging speed of one kilometer per second, thereby bringing charging experience of "charge up while you coffee up" to a user. In addition, the liquid-cooling heat dissipation manner used by the power module also helps the charging device meet a construction requirement of a full-liquid cooling ultra-fast charging station, that is, helps meet a requirement that a power module and a charging connector of each charging device in the charging station use liquid-cooling heat dissipation.

In addition, the liquid cooling component is used to implement liquid-cooling heat dissipation for both the power component body and the pin, so that utilization of the liquid cooling component can be improved, and problems of a large volume and high costs of the power module caused by disposing different heat dissipation apparatuses to dissipate heat respectively for the power component body and the pin are avoided, and miniaturization and cost optimization of the power module are facilitated.

In an implementation, the liquid cooling component includes a liquid cooling plate and an enclosure plate. The liquid cooling plate is located on a side that is of the power component body and that is away from the circuit board, and the enclosure plate is fastened to a surface that is of the liquid cooling plate and that faces the circuit board. The enclosure plate and the liquid cooling plate are enclosed to form a potting groove, and the potting groove is configured to accommodate a heat conducting adhesive. The power component body is buried in the heat conducting adhesive and is in heat-conducting connection to the liquid cooling plate via the heat conducting adhesive. One end of the heat conductor is in heat-conducting connection to the pin, and the other end of the heat conductor extends into the heat conducting adhesive and is in heat-conducting connection to the liquid cooling plate via the heat conducting adhesive.

In this embodiment of this application, a heat dissipation path is formed between the liquid cooling plate and the power component body via the heat conducting adhesive in the potting groove, and another heat dissipation path is also formed between the liquid cooling plate and the pin via the heat conducting adhesive in the potting groove and the heat conductor. In this way, the power component body and the pin of the power component can exchange heat with the cooling medium flowing in the liquid cooling plate through different heat dissipation paths. This can not only meet heat dissipation requirements of the power component body and the pin, but also accelerate a heat dissipation process of the cooling medium in the liquid cooling plate for the entire power component, thereby improving the overall heat dissipation effect of the power component.

In addition, when the heat conducting adhesive in the potting groove is used as an intermediate medium for the heat-conducting connection of the liquid cooling plate to the power component body and the pin, and the power component body is buried in the heat conducting adhesive, accumulation of dust and the like on the power component can be further reduced, and a phenomenon that the power component is corroded due to impact of a harsh environment is alleviated. This helps further prolong the service life of the power module and improve the reliability of the power module during high-power operation.

In an implementation, the power component further includes a packaging member, and the packaging member is buried in the heat conducting adhesive and wraps the power component body. One end of the pin is located in the packaging member and is fastened to the power component body, the other end of the pin extends in a direction of the circuit board and is exposed out of the packaging member, and the other end of the pin is fastened to the circuit board. The heat conductor is located outside the packaging member, the one end of the heat conductor is in heat-conducting connection to the other end of the pin, and the other end of the heat conductor extends in a direction of the heat conducting adhesive along an outer surface of the packaging member, so that the other end of the heat conductor extends into the heat conducting adhesive.

In this embodiment of this application, the other end that is of the pin and that is used to be fastened to the circuit board is in direct heat-conducting contact with the heat conductor, so that when the power component operates, heat generated by the other end of the pin can be directly and quickly transferred, via the heat conductor, to the heat conducting adhesive accommodated in the potting groove. Further, efficiency of transferring the heat of the pin to the liquid cooling plate is improved, and a heat dissipation process of the liquid cooling component for the pin is accelerated, thereby helping improve the overall heat dissipation effect of the power component.

In an implementation, the circuit board further includes a through hole, and the through hole penetrates the circuit board in a direction in which the circuit board and the power component body are arranged. The other end of the pin and the one end of the heat conductor pass through the through hole, and the other end of the pin, the one end of the heat conductor, and the through hole are fastened through welding.

In this embodiment of this application, the other end of the pin and the one end of the heat conductor are both welded and fastened to the through hole on the circuit board, to implement a heat-conducting connection between the other end of the pin, the one end of the heat conductor, and an inner wall of the through hole. When the power component operates, on one hand, the heat generated by the other end of the pin can be quickly transferred, via the heat conductor with which the other end of the pin is in direct heat-conducting contact, to the heat conducting adhesive accommodated in the potting groove. Further, the efficiency of transferring the heat of the pin to the liquid cooling plate is improved, and the heat dissipation process of the liquid cooling component for the pin is accelerated, thereby helping improve the overall heat dissipation effect of the power component. On the other hand, heat generated at the through hole at which the circuit board is fastened to the one end of the heat conductor can also be transferred to the liquid cooling plate via the heat conductor, to implement liquid-cooling heat dissipation for a position of the through hole. Further, heat dissipation effect of the power module is improved.

In an implementation, the power component further includes a packaging member, and the packaging member is buried in the heat conducting adhesive and wraps the power component body. One end of the pin is located in the packaging member and is fastened to the power component body, the other end of the pin extends in a direction of the circuit board and is exposed out of the packaging member, and the other end of the pin is fastened to the circuit board. The one end of the heat conductor is located in the packaging member and is in heat-conducting connection to the one end of the pin, and the other end of the heat conductor extends in a direction of the liquid cooling plate and is exposed out of the packaging member, so that the other end of the heat conductor extends into the heat conducting adhesive.

In this embodiment of this application, the heat conductor is partially disposed in the packaging member, so that liquid-cooling heat dissipation of the cooling medium in the liquid cooling component for the pin can be implemented by using the heat conductor, and structure compactness of the power module can be further improved.

In an implementation, the power module further includes an auxiliary heat conductor, and the auxiliary heat conductor is buried in the heat conducting adhesive. The auxiliary heat conductor is in heat-conducting connection to the other end of the heat conductor, and the auxiliary heat conductor extends in a direction parallel to the liquid cooling plate.

In this embodiment of this application, the other end of the heat conductor is in heat-conducting connection to the auxiliary heat conductor, so that a contact area between the heat conductor and the heat conducting adhesive can be increased. In this way, heat generated by the other end of the pin that is exposed out of the packaging member can be transferred to the heat conducting adhesive in the potting groove via both the heat conductor and the auxiliary heat conductor, thereby improving heat transfer efficiency at the pin. Further, the heat dissipation process of the cooling medium in the liquid cooling plate for the pin is accelerated, thereby improving overall heat dissipation effect of the power module.

In an implementation, in the direction in which the circuit board and the power component body are arranged, a height of an end surface that is of the enclosure plate and that faces the circuit board is less than a height of a surface that is of the packaging member and that faces the circuit board. In this way, in the direction in which the circuit board and the power component body are arranged, there is space between the enclosure plate and the circuit board, a part that is of the packaging member and that is away from the circuit board is buried in the heat conducting adhesive, and the other part that is of the packaging member and that is close to the circuit board is exposed out of the heat conducting adhesive.

In this embodiment of this application, the space between the enclosure plate and the circuit board is disposed, so that when another electronic element in the power module is fastened to a surface that is of the circuit board and that faces the enclosure plate, impact, due to contact between the enclosure plate and the surface that is of the circuit board and that faces the enclosure plate, on the another electronic element fastened to the circuit board can be avoided. This helps ensure normal operation of the power module and improves operation reliability of the power module.

In addition, the height of the packaging member is set to be greater than the height of the enclosure plate, so that the packaging member is partially buried in the heat conducting adhesive of the potting groove. Compared with completely burying the packaging member in the heat conducting adhesive in the potting groove, this can reduce excessive use of the enclosure plate and the heat conducting adhesive while ensuring that there is a sufficiently large contact area between the packaging member and the heat conducting adhesive, thereby helping reduce costs of the power module.

In an implementation, in the direction in which the circuit board and the power component body are arranged, projection of the enclosure plate does not overlap projection of the packaging member or projection of the heat conductor. In a direction perpendicular to the direction in which the circuit board and the power component body are arranged, projection of the liquid cooling plate does not overlap projection of the packaging member or projection of the heat conductor. In other words, in the direction in which the circuit board and the power component body are arranged, the enclosure plate is spaced from and not in contact with the packaging member, and the enclosure plate is spaced from and not in contact with the heat conductor. In addition, in the direction perpendicular to the direction in which the circuit board and the power component body are arranged, the liquid cooling plate is spaced from and not in contact with the packaging member, and the liquid cooling plate is spaced from and not in contact with the heat conductor.

In this way, a safety problem caused by contact between the enclosure plate and the packaging member and between the enclosure plate and the heat conductor can be avoided, and a safety problem caused by contact between the liquid cooling plate and the packaging member and between the liquid cooling plate and the heat conductor can also be avoided. This improves safety of the power module, and helps meet a safety requirement of the power module.

In an implementation, the enclosure plate includes an inner side surface and an outer side surface that are disposed opposite to each other. In a direction perpendicular to the direction in which the circuit board and the power component body are arranged, the inner side surface is close to the heat conducting adhesive in the potting groove, and the outer side surface is away from the heat conducting adhesive in the potting groove. In the direction in which the circuit board and the power component body are arranged, a height of a side that is of the inner side surface and that faces the circuit board is less than a height of a side that is of the outer side surface and that faces the circuit board. In this way, a concave part can be formed on the end surface that is of the enclosure plate and that faces the circuit board, and the concave part communicates with an open end of the potting groove, to increase a diameter of the open end of the potting groove. In other words, in the direction perpendicular to the direction in which the circuit board and the power component body are arranged, a distance between a part that is of the inner side surface and that is located at the open end of the potting groove and the packaging member and a distance between the part and the heat conductor are longer than a distance between another part of the inner side surface and the packaging member and a distance between the another part and the heat conductor.

In this way, voltage breakdown caused by an excessively small distance between the enclosure plate at the open end of the potting groove and the heat conductor and an excessively small distance between the enclosure plate and the packaging member can be avoided. Further, this can improve the safety of the power module, and helps meet the safety requirement of the power module.

According to a second aspect, a charging device is provided. The charging device includes a power module and at least one charging interface, the power module is electrically connected to the at least one charging interface, and the power module is configured to output power to an electric vehicle through the at least one charging interface. The power module includes a circuit board, a power component, a heat conductor, and a liquid cooling component, where the power component is located between the circuit board and the liquid cooling component. The power component includes a power component body and a pin, the power component body is fastened to a surface of the circuit board via the pin, the power component body is in heat-conducting connection to the liquid cooling component, and the pin is in heat-conducting connection to the liquid cooling component via the heat conductor. The liquid cooling component is configured to exchange heat with the power component body and the heat conductor.

For beneficial effect that is not described in detail in the second aspect, refer to the beneficial effect in the first aspect. Details are not described herein again.

### BRIEF DESCRIPTION OF DRAWINGS

FIG. 1 is a diagram of a structure of a charging system according to an embodiment of this application;
FIG. 2 is a diagram of a connection structure of the charging system shown in FIG. 1;
FIG. 3 is a diagram of a structure of a power module according to an embodiment of this application;
FIG. 4 is a diagram of a structure of another power module according to an embodiment of this application;
FIG. 5 is a diagram of a main-view structure of another power module according to an embodiment of this application; and
FIG. 6 is a diagram of a side-view structure of the power module shown in FIG. 5.

### DESCRIPTION OF EMBODIMENTS

For ease of understanding of embodiments of this application, the following descriptions are first provided before embodiments of this application are described.

In embodiments of this application, an orientation or a position relationship indicated by terms "upper", "lower", "left", "right", "front", "rear", "top", "bottom", "inside", "outside", or the like is an orientation or position relationship shown in the accompanying drawings, and is merely intended to facilitate description and simplify description of this application, but is not intended to indicate or imply that the mentioned apparatus or element needs to have a particular orientation or needs to be constructed and operated in a particular orientation. Therefore, such terms should not be understood as a limitation on this application.

In this application, "perpendicular" is not strictly perpendicular, but within an allowable error range. "Parallel" is not strictly parallel, but within an allowable error range.

In embodiments of this application, a same reference numeral indicates a same component or a same part. In embodiments of this application, for a plurality of same parts, only one of the parts marked with a reference numeral may be used as an example in the figure. For another same part or component, reference numerals are also applicable. In addition, dimensions and sizes of the parts shown in the accompanying drawings are merely examples.

Embodiments of this application provide a power module. The power module includes a circuit board, a power component, a heat conductor, and a liquid cooling component, where the power component is located between the circuit board and the liquid cooling component. The power component includes a power component body and a pin, and the power component body is fastened to a surface of the circuit board via the pin. The power component body is in heat-conducting connection to the liquid cooling component, the pin is in heat-conducting connection to the liquid cooling component via the heat conductor, and the liquid cooling component is configured to exchange heat with the power component body and the heat conductor.

In the power module provided in embodiments of this application, a cooling medium in the liquid cooling component may not only exchange heat with the power component body to which the liquid cooling component is in heat-conducting connection, but also exchange heat with the pin of the power component via the heat conductor, to take away heat generated by the power component body and the pin, and implement liquid-cooling heat dissipation for the power component body and the pin. In addition, compared with air-cooling heat dissipation, liquid-cooling heat dissipation is more efficient. Further, this improves overall heat dissipation effect of the power component, and helps meet a heat dissipation requirement of the power component during high-power operation, and prolong a service life of the power module and improve reliability of the power module during high-power operation.

In addition, the liquid cooling component is used to implement liquid-cooling heat dissipation for both the power component body and the pin, so that utilization of the liquid cooling component can be improved, and problems of a large volume and high costs of the power module caused by disposing different heat dissipation apparatuses to dissipate heat respectively for the power component body and the pin are avoided, and miniaturization and cost optimization of the power module are facilitated.

Embodiments of this application further provide a charging device. The charging device includes the foregoing power module and at least one charging interface. The power module is electrically connected to the at least one charging interface, and the at least one charging interface is configured to electrically connect to an electric vehicle. The power module is configured to output power to the electric vehicle through the at least one charging interface, to charge the electric vehicle. As described above, the heat dissipation effect of the power module is good, and can meet the heat dissipation requirement of the power module during high-power operation. This helps the charging device implement a charging speed of one kilometer per second, that is, supplement electric energy of one kilometer of driving range per second for the electric vehicle, thereby bringing charging experience of "charge up while you coffee up" to a user. In addition, the liquid-cooling heat dissipation manner used by the power module also helps the charging device meet a construction requirement of a full-liquid cooling ultra-fast charging station, that is, helps meet a requirement that a power module and a charging connector of each charging device in the charging station use liquid-cooling heat dissipation.

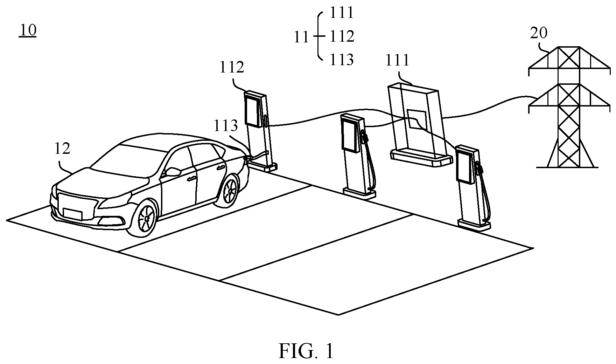

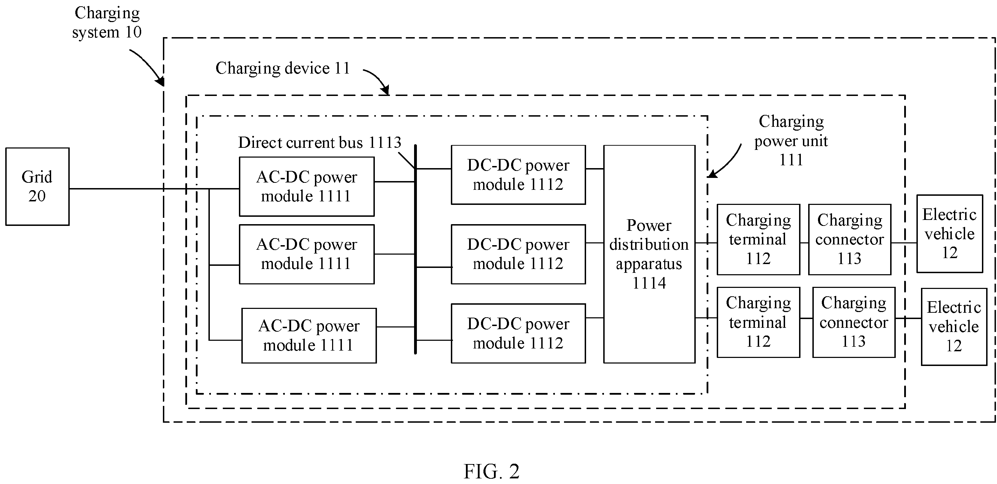

The charging device provided in embodiments of this application may be used in a charging system including an electric vehicle. In the charging system, the charging device may use electric energy from a grid to charge the electric vehicle. The following first describes in detail the charging system provided in embodiments of this application with reference to FIG. 1 and FIG. 2.

FIG. 1 is a diagram of a structure of a charging system 10 according to an embodiment of this application. FIG. 2 is a diagram of a connection structure of the charging system 10 shown in FIG. 1.

With reference to FIG. 1 and FIG. 2, the charging system 10 includes a charging device 11 and an electric vehicle 12. The charging device 11 includes a charging power unit 111, at least one charging terminal 112, and at least one charging connector 113. In other words, the charging device 11 may be a split-type charging pile.

The charging power unit 111 includes a plurality of alternating current-direct current (alternating current-direct current, AC-DC) power modules 1111, a plurality of direct current-direct current (direct current-direct current, DC-DC) power modules 1112, a direct current bus 1113, a power distribution apparatus 1114, and at least one charging interface. The plurality of AC-DC power modules 1111 are connected in parallel between an external grid 20 and the direct current bus 1113. Input ends of the plurality of DC-DC power modules 1112 are electrically connected to the direct current bus 1113, and output ends of the plurality of DC-DC power modules 1112 are electrically connected to an input end of the power distribution apparatus 1114. An output end of the power distribution apparatus 1114 is electrically connected to at least one charging interface. During specific implementation, each charging interface may be electrically connected to one charging terminal 112, and each charging terminal 112 is electrically connected to at least one charging connector 113.

The plurality of AC-DC power modules 1111 are configured to: receive an alternating current from the external grid 20, convert the alternating current into a direct current, and output the direct current to the direct current bus 1113. The plurality of DC-DC power modules 1112 are configured to: obtain the direct current from the direct current bus 1113, convert the obtained direct current into a direct current applicable to the electric vehicle 12, and then transmit the direct current to the power distribution apparatus 1114. The power distribution apparatus 1114 is configured to: dynamically distribute, based on charging power actually required by the electric vehicle 12, the direct current output by the plurality of DC-DC power modules 1112, and transmit distributed charging power to the electric vehicle 12 via the charging connector 113 connected to the charging terminal 112, to charge the electric vehicle 12.

The charging terminal 112 outputs the received direct current to the electric vehicle 12 via the electrically connected charging connector 113, to charge the electric vehicle 12. For example, the charging terminal 112 includes a housing, a human-machine interaction interface, a charging control unit, a metering and billing unit, and the like, and is configured to: perform information exchange, energy transmission, metering and billing, and the like with the electric vehicle 12.

The electric vehicle 12 is a means of transportation driven by electric energy. The electric vehicle 12 may be a pure electric vehicle (pure electric vehicle/battery electric vehicle, pure EV/battery EV), a hybrid electric vehicle (hybrid electric vehicle, HEV), a range extended electric vehicle (range extended electric vehicle, REEV), a plug-in hybrid electric vehicle (plug-in hybrid electric vehicle, PHEV), or the like.

It should be understood that this embodiment of this application is described by using an example in which the charging device 11 is the split-type charging pile. In some other embodiments, the charging device 11 may alternatively be an integrated charging pile. Specifically, the charging device 11 may directly dispose the human-machine interaction interface, the charging control unit, the metering and billing unit, and the like in the charging power unit 111, so that the charging device 11 may not include the charging terminal 112, but includes the charging power unit 111 and the at least one charging connector 113 electrically connected to the charging power unit 111.

It should be further understood that this embodiment of this application is described by using an example in which the charging device 11 includes the AC-DC power module 1111 and the DC-DC power module 1112. In some other embodiments, the charging device 11 may include only the AC-DC power module 1111, and does not include the DC-DC power module 1112.

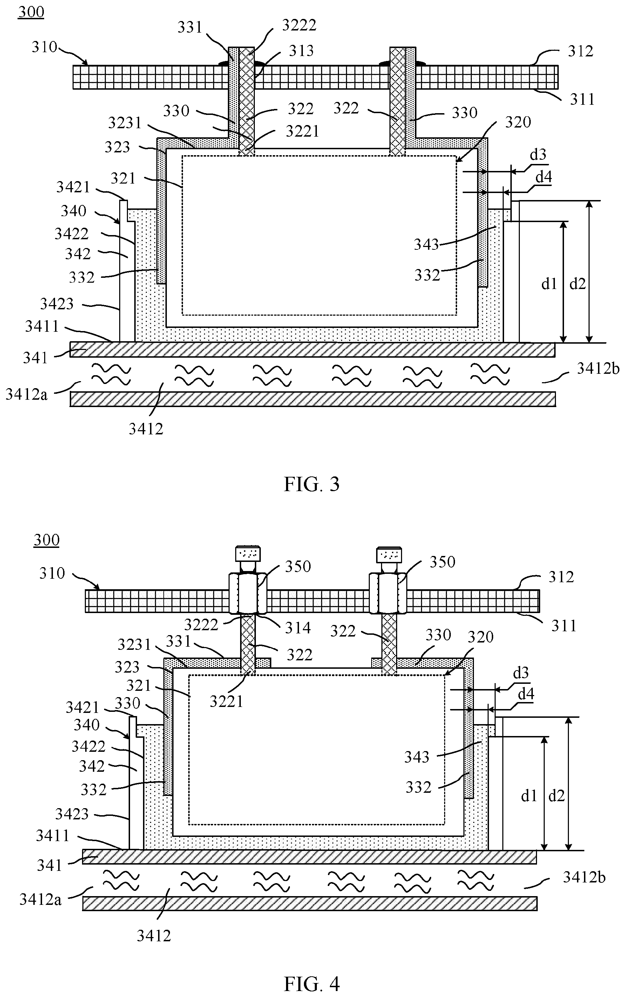

The following describes in detail a specific structure of a power module provided in embodiments of this application with reference to FIG. 3 to FIG. 6.

FIG. 3 and FIG. 4 each are a diagram of a structure of a power module 300 according to an embodiment of this application. It should be understood that, in this embodiment of this application, the power module 300 may be the AC-DC power module 1111 shown in FIG. 2, or the power module 300 may be the DC-DC power module 1112 shown in FIG. 2.

It should be noted that, for ease of description and understanding, the following embodiments are described by using an example in which the power module 300 is used in a charging device in a charging system. In some other embodiments, the power module 300 may also be used in another scenario like an energy storage system or a photovoltaic plus storage system.

With reference to FIG. 3 and FIG. 4, the power module 300 includes a circuit board 310, a power component 320, a heat conductor 330, and a liquid cooling component 340.

The power component 320, the heat conductor 330, and the liquid cooling component 340 are located on a same side of the circuit board 310, and the power component 320 is located between the circuit board 310 and the liquid cooling component 340. The circuit board 310 is configured to fasten the power component 320 and electrically connect to the power component 320. The heat conductor 330 is configured to connect, in a heat-conducting manner, the power component 320 to the liquid cooling component 340, to transfer heat generated by the power component 320 to the liquid cooling component 340. The liquid cooling component 340 is configured to be in heat-conducting connection to the power component 320 and the heat conductor 330.

In this way, a cooling medium circulating in the liquid cooling component 340 can not only directly exchange heat with the power component 320, but also exchange heat with the power component 320 via the heat conductor 330, to take away heat generated by the power component 320, and implement liquid-cooling heat dissipation for the power component 320. Compared with a common air-cooling heat dissipation manner, the liquid-cooling heat dissipation manner has higher heat dissipation efficiency, so that heat dissipation effect of the power component 320 can be improved, and a heat dissipation requirement of the power component 320 during high-power operation can be met.

The following specifically describes the components in the power module 300 mentioned above.

With reference to FIG. 3 and FIG. 4, in some embodiments, the circuit board 310 includes a first circuit board surface 311 and a second circuit board surface 312 that are disposed opposite to each other. The power component 320 is fastened to the circuit board 310, and the first circuit board surface 311 may be fastened, for example, via a fastener (not shown in the figure), to an enclosure plate 342 in the liquid cooling component 340 described below.

In this embodiment of this application, the circuit board 310 may be a printed circuit board (printed circuit board, PCB), a ceramic circuit board, an aluminum oxide ceramic circuit board, an aluminum nitride ceramic circuit board, a line board, an aluminum substrate, a high-frequency board, an impedance board, or the like. For ease of description and understanding, this embodiment of this application is described by using an example in which the circuit board 310 is the printed circuit board.

It should be understood that, in this embodiment of this application, there may be one or more power components 320 in the power module 300. For ease of description and understanding, this embodiment of this application is described by using one power component 320 in the power module 300 as an example.

For example, the power component 320 may be a high-power component that generates heat consumption during operation like a relay, a fuse, or a transformer.

Still with reference to FIG. 3 and FIG. 4, in some embodiments, the power component 320 includes a power component body 321 and a pin 322. The power component body 321 is located between the circuit board 310 and the liquid cooling component 340, and the power component body 321 is fastened to one side of the circuit board 310 via the pin 322.

It should be understood that, in this embodiment of this application, the power component body 321 may be a part that is of the power component 320 and that is configured to operate, and the pin 322 may be a part that is of the power component 320 and that is configured to connect to another circuit element, for example, configured to connect to the circuit board 310. The pin 322 may transmit a current.

It should be further understood that, in this embodiment of this application, the power component body 321 may be fastened to one side of the circuit board 310 via one or more pins 322. For ease of description and understanding, this embodiment of this application is described by using an example in which the power component body 321 is fastened to one side of the circuit board 310 via two pins 322.

Further, in some embodiments, the power component 320 further includes a packaging member 323, and the packaging member 323 is configured to package the power component body 321. Specifically, the packaging member 323 wraps the power component body 321, one end 3221 of the pin 322 is located in the packaging member 323 and is fastened to the power component body 321, and the other end 3222 of the pin 322 extends in a direction of the circuit board 310 and is exposed out of the packaging member 323, to be fastened to the circuit board 310.

It should be understood that, in this embodiment of this application, the packaging member 323 wrapping the power component body 321 means that the power component body 321 is completely wrapped by the packaging member 323.

During specific implementation, in some embodiments, the other end 3222 of the pin 322 may be fastened to the circuit board 310 through welding, or may be fastened to the circuit board 310 via a fastener 350.

In an example, refer to FIG. 3. The circuit board 310 further includes a welding through hole 313, and the welding through hole 313 penetrates the circuit board 310 in a direction in which the circuit board 310 and the power component body 321 are arranged. In other words, the welding through hole 313 penetrates the circuit board 310 in a direction in which the first circuit board surface 311 and the second circuit board surface 312 of the circuit board 310 are arranged. The other end 3222 that is of the pin 322 and that is exposed out of the packaging member 323 extends to the circuit board 310 and passes through the welding through hole 313, and the other end 3222 of the pin 322 is fastened to the welding through hole 313 through welding.

In another example, refer to FIG. 4. The power module 300 further includes the fastener 350, and the circuit board 310 further includes a mounting through hole 314. The mounting through hole 314 penetrates the circuit board 310 in the direction in which the circuit board 310 and the power component body 321 are arranged. In other words, the mounting through hole 314 penetrates the circuit board 310 in the direction in which the first circuit board surface 311 and the second circuit board surface 312 of the circuit board 310 are arranged.

The other end 3222 that is of the pin 322 and that is exposed out of the packaging member 323 extends to the circuit board 310 and passes through the mounting through hole 314. The fastener 350 is located on a side that is of the circuit board 310 and that is away from the power component body 321, and the fastener 350 is configured to be assembled with the mounting through hole 314 to fasten the pin 322 to the circuit board 310. The fastener 350 may be, for example, a rivet nut or a rivet screw. In other words, the other end 3222 of the pin 322 may be fastened to the circuit board 310 through a riveting.

Still with reference to FIG. 3 and FIG. 4, in some embodiments, the power component body 321 is in heat-conducting connection to the liquid cooling component 340, and the pin 322 is in heat-conducting connection to the liquid cooling component 340 via the heat conductor 330. The heat conductor 330 is a connecting piece that can transfer heat, for example, may be a metal copper strip or a metal aluminum strip.

It should be understood that, when the power component 320 operates, the power component body 321 generates a large amount of heat, and the pin 322 of the power component 320 also generates a specific amount of heat. If the heat cannot be discharged in time, a service life of the power component 320 and reliability of a welding position between the pin 322 and the circuit board 310 are also affected.

In this embodiment of this application, the power component 320 is disposed between the circuit board 310 and the liquid cooling component 340, and the power component body 321 is in heat-conducting connection to the liquid cooling component 340, so that the heat generated by the power component body 321 may be transferred to the cooling medium in the liquid cooling component 340 through heat-conducting contact, to implement liquid-cooling heat dissipation for the power component body 321. In addition, the pin 322 is in heat-conducting connection to the liquid cooling component 340 via the heat conductor 330, so that the heat generated by the pin 322 can be transferred, via the heat conductor 330, to the liquid cooling component 340 that is far away from the pin 322, to implement liquid-cooling heat dissipation for the pin 322.

In other words, in this embodiment of this application, there is a heat dissipation path between the power component body 321 and the liquid cooling component 340, and there is another heat dissipation path between the pin 322, the heat conductor 330, and the liquid cooling component 340, that is, the power component body 321 and the pin 322 exchange heat with the liquid cooling component 340 through different heat dissipation paths. This can not only meet heat dissipation requirements of the power component body 321 and the pin 322, but also accelerate a heat dissipation process of the liquid cooling component 340 for the entire power component 320. Further, this improves overall heat dissipation effect of the power component 320, and helps meet the heat dissipation requirement of the power component 320 during high-power operation, and prolong a service life of the power module 300 and improve reliability of the power module 300 during high-power operation.

In addition, the liquid cooling component 340 is used to implement liquid-cooling heat dissipation for both the power component body 321 and the pin 322, so that utilization of the liquid cooling component 340 can be improved, and problems of a large volume and high costs of the power module 300 caused by dissipating heat respectively for the power component body 321 and the pin 322 by different heat dissipation apparatuses are avoided, and miniaturization and cost optimization of the power module 300 are facilitated.

For example, when the power component 320 includes a plurality of pins 322, there may be a plurality of heat conductors 330 in the power module 300, the plurality of heat conductors 330 one-to-one correspond to the plurality of power components 320, and a pin 322 of each power component 320 is in heat-conducting connection to the liquid cooling component 340 via a corresponding heat conductor 330. In other words, heat generated by the plurality of pins 322 of the power component 320 is transferred to the liquid cooling component 340 via different heat conductors 330. This helps accelerate a heat dissipation process of the liquid cooling component 340 for the plurality of pins 322, and further improve overall heat dissipation effect of the power module 300.

The following continues to specifically describe the liquid cooling component 340 in the power module 300 with reference to FIG. 3 and FIG. 4.

Still with reference to FIG. 3 and FIG. 4, in some embodiments, the liquid cooling component 340 includes a liquid cooling plate 341 and the enclosure plate 342. The liquid cooling plate 341 is located on a side that is of the power component body 321 and that is away from the circuit board 310, and the enclosure plate 342 is fastened to a surface 3411 that is of the liquid cooling plate 341 and that faces the circuit board 310. The enclosure plate 342 and the surface 3411 that is of the liquid cooling plate 341 and that faces the circuit board 310 are enclosed to form a potting groove 343, and an opening of the potting groove 343 faces the circuit board 310.

Specifically, one end of the enclosure plate 342 is fastened to the surface 3411 that is of the liquid cooling plate 341 and that faces the circuit board 310, and the other end of the enclosure plate 342 extends in the direction of the circuit board 310. The enclosure plate 342 is used as a side wall of the potting groove 343, and the surface 3411 that is of the liquid cooling plate 341 and that faces the circuit board 310 is used as a bottom surface of the potting groove 343. The potting groove 343 is configured to accommodate a heat conducting adhesive. The heat conducting adhesive is in heat-conducting connection to the bottom surface of the potting groove 343, that is, the surface 3411 that is of the liquid cooling plate 341 and that faces the circuit board 310, and is further in heat-conducting connection to the cooling medium in the liquid cooling plate 341.

In some embodiments, with reference to FIG. 3 and FIG. 4, a liquid cooling channel 3412 is disposed on the liquid cooling plate 341, and the liquid cooling channel 3412 includes a liquid inlet 3412a and a liquid outlet 3412b. The liquid inlet 3412a and the liquid outlet 3412b are disposed opposite to each other in a direction parallel to the liquid cooling plate 341. The liquid inlet 3412a is used to communicate with an input end of an external cooling system, and the liquid outlet 3412b is used to communicate with an output end of the external cooling system.

In this way, the cooling medium in the external cooling system may flow into the liquid cooling channel 3412 through the liquid inlet 3412a, and flow out of the liquid cooling channel 3412 through the liquid outlet 3412b. The cooling medium in the liquid cooling channel 3412 may be in heat-conducting connection to the heat conducting adhesive in the potting groove 343 through the surface 3411 that is of the liquid cooling plate 341 and that faces the circuit board 310.

It should be understood that, in this embodiment of this application, the external cooling system may be a cooling system that is located outside the power module 300 and that can provide a cooling medium for the liquid cooling channel 3412 and can reduce a temperature of the cooling medium transmitted to the liquid cooling channel 3412.

Further, in some embodiments, the power component body 321 is buried in the heat conducting adhesive and is in heat-conducting connection to the heat conducting adhesive. Specifically, the packaging member 323 is buried in the heat conducting adhesive and wraps the power component body 321. In other words, the power component body 321 is in heat-conducting connection to the heat conducting adhesive via the packaging member 323. In addition, one end 331 of the heat conductor 330 is in heat-conducting connection to the pin 322, and the other end 332 of the heat conductor 330 extends into the heat conducting adhesive and is in heat-conducting connection to the heat conducting adhesive.

In this way, the power component body 321 can be in heat-conducting connection to the cooling medium in the liquid cooling plate 341 via the heat conducting adhesive in the potting groove 343. The pin 322 may be in heat-conducting connection to the cooling medium in the liquid cooling plate 341 via the heat conductor 330 and the heat conducting adhesive in the potting groove 343.

It should be understood that, in this embodiment of this application, the packaging member 323 being buried in the heat conducting adhesive means that the packaging member 323 is at least partially wrapped by the heat conducting adhesive.

During specific implementation, the cooling medium in the external cooling system flows into the liquid cooling channel 3412 through the liquid inlet 3412a of the liquid cooling channel 3412. On one hand, the cooling medium in the liquid cooling channel 3412 exchange heat with the power component body 321 via the liquid cooling plate 341 and the heat conducting adhesive, to take away the heat generated by the power component body 321, and implement liquid-cooling heat dissipation for the power component body 321. On the other hand, the cooling medium in the liquid cooling channel 3412 exchanges heat with the pin 322 via the liquid cooling plate 341, the heat conducting adhesive, and the heat conductor 330, to take away the heat generated by the pin 322, and implement liquid-cooling heat dissipation for the pin 322.

Then, the cooling medium carrying the heat flows back to the external cooling system through the liquid outlet 3412b of the liquid cooling channel 3412. The external cooling system is used to cool the cooling medium carrying the heat, and the cooled cooling medium flows into the liquid cooling channel 3412 through the liquid inlet 3412a of the liquid cooling channel 3412, to implement cyclical use of the cooling medium in the liquid cooling plate 341, so as to implement cyclical heat dissipation of the liquid cooling plate 341 on the power component body 321 and the pin 322.

It should be understood that a specific manner in which the heat conductor 330 is in heat-conducting connection to the pin 322 and the heat conducting adhesive is described below. To avoid repetition, the foregoing is merely a brief description.

In this embodiment of this application, a heat dissipation path is formed between the liquid cooling plate 341 and the power component body 321 via the heat conducting adhesive in the potting groove 343, and a heat dissipation path is formed between the liquid cooling plate 341 and the pin 322 of the power component 320 via the heat conducting adhesive in the potting groove 343 and the heat conductor 330. In this way, the power component body 321 and the pin 322 exchange heat, through different heat dissipation paths, with the cooling medium flowing in the liquid cooling channel 3412 of the liquid cooling plate 341. This not only helps meet the heat dissipation requirements of the power component body 321 and the pin 322 of the power component 320, but also helps accelerate the heat dissipation process of the cooling medium in the liquid cooling channel 3412 for the entire power component 320, thereby improving the overall heat dissipation effect of the power component 320.

In addition, when the heat conducting adhesive in the potting groove 343 is used as an intermediate medium for the heat-conducting connection of the liquid cooling plate 341 to the power component body 321 and the pin 322, and the power component body 321 is buried in the heat conducting adhesive, accumulation of dust and the like on the power component 320 can be further reduced, and a problem that the power component 320 is corroded due to impact of a harsh environment is alleviated. This helps further prolong the service life of the power component 320 and improve the reliability of the power component 320 during high-power operation.

Further, in some embodiments, still with reference to FIG. 3 and FIG. 4, in the direction in which the circuit board 310 and the power component body 321 are arranged, a height of an end surface 3421 that is of the enclosure plate 342 and that faces the circuit board 310 is less than a height of an outer surface 3231 that is of the packaging member 323 and that faces the circuit board 310. In other words, in the direction in which the circuit board 310 and the power component body 321 are arranged, the height of the circuit board 310 is greater than the height of the packaging member 323, and the height of the packaging member 323 is greater than the height of the enclosure plate 342.

In this way, in the direction in which the circuit board 310 and the power component body 321 are arranged, there is space between the end surface 3421 that is of the enclosure plate 342 and that faces the circuit board 310 and the first circuit board surface 311 that is of the circuit board 310 and that faces the power component body 321, a part that is of the packaging member 323 and that is away from the circuit board 310 is buried in the heat conducting adhesive, and the other part that is of the packaging member 323 and that is close to the circuit board 310 is exposed out of the heat conducting adhesive.

In this embodiment of this application, the space between the enclosure plate 342 and the circuit board 310 is disposed, so that impact, due to contact between the enclosure plate 342 and the first circuit board surface 311 of the circuit board 310, on another electronic element in the power module 300 fastened to the first circuit board surface 311 can be avoided. This helps ensure normal operation of the power module 300 and improves operation reliability of the power module 300.

In addition, the height of the packaging member 323 is set to be greater than the height of the enclosure plate 342, so that the packaging member 323 is partially buried in the heat conducting adhesive of the potting groove 343. Compared with completely burying the packaging member 323 in the heat conducting adhesive in the potting groove 343, this can reduce excessive use of the enclosure plate 342 and the heat conducting adhesive while ensuring that there is a sufficient contact area between the packaging member 323 and the heat conducting adhesive, thereby helping reduce costs of the power module 300.

With reference to the accompanying drawings, the following describes, by using an example, a specific manner in which the heat conductor 330 is in heat-conducting connection to the pin 322 and the heat conducting adhesive mentioned above.

Still with reference to FIG. 3 and FIG. 4, in some embodiments, when the one end 3221 of the pin 322 of the power component 320 is located in the packaging member 323 and is fastened to the power component body 321, and the other end 3222 of the pin 322 extends in the direction of the circuit board 310 and is exposed out of the packaging member 323, to be fastened to the circuit board 310, the heat conductor 330 is located outside the packaging member 323.

The one end 331 of the heat conductor 330 is in heat-conducting connection to the other end 3222 of the pin 322. In other words, the one end 331 of the heat conductor 330 is in heat-conducting connection to the part that is of the pin 322 and that is exposed out of the packaging member 323. The other end 332 of the heat conductor 330 extends in a direction of the potting groove 343 along an outer surface of the packaging member 323, and extends into the heat conducting adhesive accommodated in the potting groove 343. In other words, the heat conductor 330 is attached to the outer surface of the packaging member 323, and extends, along the part that is of the pin 322 and that is exposed out of the packaging member 323, in the direction of the potting groove 343.

In this embodiment of this application, the other end 3222 that is of the pin 322 and that is used to be fastened to the circuit board 310 is in direct heat-conducting contact with the heat conductor 330, so that when the power component 320 operates, heat generated by the other end 3222 of the pin 322 can be directly and quickly transferred, via the heat conductor 330, to the heat conducting adhesive accommodated in the potting groove 343, and further transferred to the cooling medium in the liquid cooling plate 341 via the heat conducting adhesive. Further, efficiency of transferring the heat of the pin 322 to the cooling medium is improved, and a heat dissipation process of the liquid cooling component 340 for the pin 322 is accelerated, thereby helping improve the overall heat dissipation effect of the power component 320.

For example, as shown in FIG. 3 and FIG. 4, the other end 332 of the heat conductor 330 may be bent and extended in the direction of the potting groove 343, so that the heat conductor 330 can be better attached to the outer surface of the packaging member 323. In this way, the overall heat dissipation effect of the power component 320 is improved, and structural compactness of the power module 300 is also improved.

It should be understood that the foregoing embodiment is described by using an example in which the power component 320 includes the packaging member 323 and the heat conductor 330 is attached to the outer surface of the packaging member 323. In some other embodiments, the packaging member 323 may not be disposed in the power component 320. In this case, the heat conductor 330 may be directly attached to an outer surface of the power component body 321.

For example, in an example, the power component 320 further includes an insulation layer (not shown in the figure), and the heat conductor 330 is attached to the outer surface of the power component body 321 through the insulation layer. In this way, the insulation layer can electrically insulate and isolate the heat conductor 330 from the power component body 321. This can further improve safety of the power module 300, and helps meet safety requirement of the power module 300.

Further, in some embodiments, as shown in FIG. 3, when the pin 322 of the power component 320 is welded and connected to the circuit board 310, the other end 3222 that is of the pin 322 and that is exposed out of the packaging member 323 and the one end 331 of the heat conductor 330 pass through the welding through hole 313 together, and the other end 3222 of the pin 322, the one end 331 of the heat conductor 330, and the welding through hole 313 are fastened through welding.

In this embodiment of this application, the other end 3222 of the pin 322 and the one end 331 of the heat conductor 330 are both welded and connected to the welding through hole 313 on the circuit board 310, to implement a heat-conducting connection between the other end 3222 of the pin 322, the one end 331 of the heat conductor 330, and an inner wall of the welding through hole 313. When the power component 320 operates, on one hand, the heat generated by the other end 3222 of the pin 322 can be quickly transferred, via the heat conductor 330, to the heat conducting adhesive accommodated in the potting groove 343, thereby accelerating the heat dissipation process of the liquid cooling component 340 for the pin 322. On the other hand, heat generated in a position that is on the circuit board 310 and in which the circuit board 310 is welded and connected to the pin 322 can also be transferred, via the heat conductor 330, to the heat conducting adhesive accommodated in the potting groove 343. Further, the overall heat dissipation effect of the power module 300 is improved.

In some embodiments, still with reference to FIG. 3 and FIG. 4, in the direction in which the circuit board 310 and the power component body 321 are arranged, projection of the enclosure plate 342 does not overlap projection of the packaging member 323 or projection of the heat conductor 330. In other words, in the direction in which the circuit board 310 and the power component body 321 are arranged, the enclosure plate 342 is spaced from and not in contact with the packaging member 323, and the enclosure plate 342 is spaced from and not in contact with the heat conductor 330 attached to the outer surface of the packaging member 323. This helps avoid a safety problem caused by contact between the enclosure plate 342 and the heat conductor 330 and between the enclosure plate 342 and the packaging member 323, improves the safety of the power module 300, and helps meet the safety requirement of the power module 300.

Similarly, in some other embodiments, still with reference to FIG. 3 and FIG. 4, in a direction perpendicular to the direction in which the circuit board 310 and the power component body 321 are arranged, projection of the liquid cooling plate 341 does not overlap projection of the packaging member 323 or projection of the heat conductor 330. In other words, in the direction perpendicular to the direction in which the circuit board 310 and the power component body 321 are arranged, the liquid cooling plate 341 is spaced from and not in contact with the packaging member 323, and the liquid cooling plate 341 is spaced from and not in contact with the heat conductor 330. This helps avoid a safety problem caused by contact between the liquid cooling plate 341 and the heat conductor 330 and between the liquid cooling plate 341 and the packaging member 323, improves the safety of the power module 300, and helps meet the safety requirement of the power module 300.

In some embodiments, still with reference to FIG. 3 and FIG. 4, the enclosure plate 342 includes an inner side surface 3422 and an outer side surface 3423 that are disposed opposite to each other. In the direction perpendicular to the direction in which the circuit board 310 and the power component body 321 are arranged, the inner side surface 3422 is close to the heat conducting adhesive in the potting groove 343, and the outer side surface 3423 is away from the heat conducting adhesive in the potting groove 343. In the direction in which the circuit board 310 and the power component body 321 are arranged, a height d1 of a side that is of the inner side surface 3422 and that faces the circuit board 310 is less than a height d2 of a side that is of the outer side surface 3423 and that faces the circuit board 310, that is, d1 is less than d2. In this way, a concave part can be formed on the end surface 3421 that is of the enclosure plate 342 and that faces the circuit board 310, and the concave part communicates with an open end of the potting groove 343.

In actual application, the concave part may be used as a part of the open end of the potting groove 343, to increase a diameter of the open end of the potting groove 343. In other words, in the direction perpendicular to the direction in which the circuit board 310 and the power component body 321 are arranged, a distance between a part that is of the inner side surface 3422 and that is located at the open end of the potting groove 343 and the packaging member 323 and a distance between the part and the heat conductor 330 attached to the outer surface of the packaging member 323 are longer than a distance between another part of the inner side surface 3422 and the packaging member 323 and a distance between the another part and the heat conductor 330. This helps avoid voltage breakdown caused by an excessively small distance between the enclosure plate 342 at the open end of the potting groove 343 and the heat conductor 330 and an excessively small distance between the enclosure plate 342 and the packaging member 323. Further, this can improve the safety of the power module 300, and helps meet the safety requirement of the power module 300.

In an example, as shown in FIG. 3 and FIG. 4, in the direction perpendicular to the direction in which the circuit board 310 and the power component body 321 are arranged, a distance d3 between the part that is of the inner side surface 3422 and that is located at the open end of the potting groove 343 and the heat conductor 330 attached to the outer surface of the packaging member 323 is greater than or equal to 5 mm, and a distance d4 between the part of the inner side surface 3422 other than the open end of the potting groove 343 and the heat conductor 330 attached to the outer surface of the packaging member 323 is less than 5 mm. In other words, d3 is greater than or equal to 5 mm, and d4 is less than 5 mm, so that the diameter of the open end of the potting groove 343 is larger. This helps improve the safety of the power module 300, and meet the safety requirement of the power module 300.

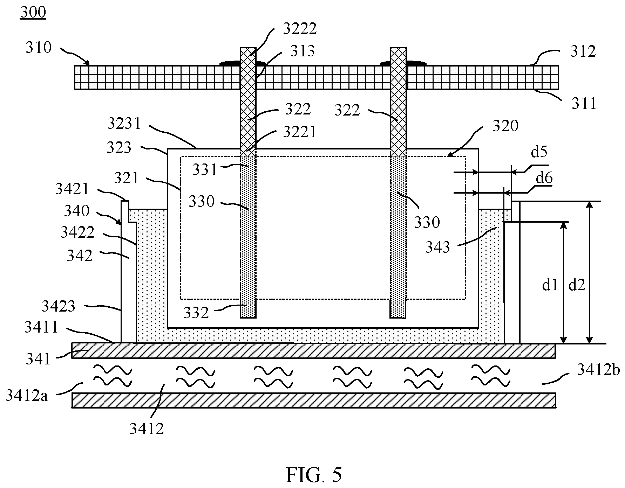

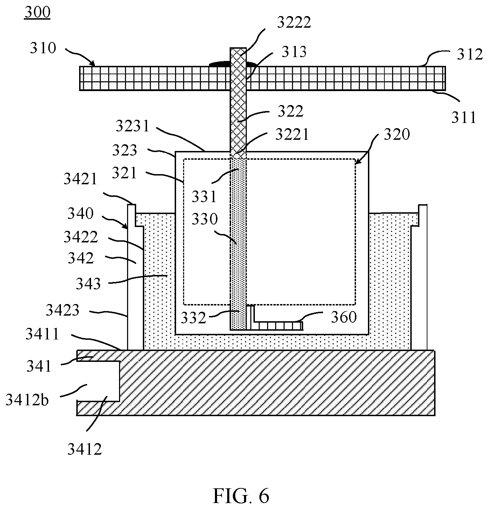

FIG. 5 is a diagram of a main-view structure of another power module 300 according to an embodiment of this application. FIG. 6 is a diagram of a side-view structure of the power module 300 shown in FIG. 5. It should be understood that the power module 300 shown in FIG. 5 and FIG. 6 includes most technical features of the embodiments shown in FIG. 3 and FIG. 4. To avoid repetition, the following mainly describes differences between the embodiments shown in FIG. 5 and FIG. 6 and the embodiments shown in FIG. 3 and FIG. 4.

Different from the embodiments shown in FIG. 3 and FIG. 4, in the embodiments shown in FIG. 5 and FIG. 6, when the one end 3221 of the pin 322 of the power component 320 is located in the packaging member 323 and is fastened to the power component body 321, and the other end 3222 of the pin 322 extends in the direction of the circuit board 310 and is exposed out of the packaging member 323, to be fastened to the circuit board 310, the heat conductor 330 is partially located inside the packaging member 323. Specifically, the one end 331 of the heat conductor 330 is located inside the packaging member 323, and the one end 331 of the heat conductor 330 is in heat-conducting connection to the one end 3221 that is of the pin 322 and that is located inside the packaging member 323. The other end 332 of the heat conductor 330 extends in a direction of the liquid cooling plate 341, is exposed out of the packaging member 323, and extends into the heat conducting adhesive accommodated in the potting groove 343.

In this way, when the power component 320 operates, the heat generated by the other end 3222 that is of the pin 322 and that is exposed out of the packaging member 323 is first transferred to the one end 3221 that is of the pin 322 and that is located in the packaging member 323, then transferred, via the heat conductor 330 that is in heat-conducting connection to the one end 3221 of the pin 322, to the heat conducting adhesive accommodated in the potting groove 343, and further transferred to the cooling medium in the liquid cooling plate 341 via the heat conducting adhesive, to implement liquid-cooling heat dissipation for the pin 322.

It should be understood that, during specific implementation, the power component 320 usually further includes a copper bar, and the one end 3221 of the pin 322 is welded to the copper bar. The copper bar extends in the direction of the liquid cooling plate 341, and is partially exposed out of the packaging member 323, to be in heat-conducting connection to the heat conducting adhesive in the potting groove 343. In other words, the heat conductor 330 may be the copper bar disposed in the power component 320.

In this embodiment of this application, the heat conductor 330 is partially disposed in the packaging member 323, so that liquid-cooling heat dissipation of the cooling medium in the liquid cooling plate 341 for the pin 322 can be implemented by using the heat conductor 330, and the structure compactness of the power module 300 can be further improved.

Further, in some embodiments, as shown in FIG. 6, the power module 300 further includes an auxiliary heat conductor 360. The auxiliary heat conductor 360 is buried in the heat conducting adhesive of the potting groove 343 and is in heat-conducting connection to the heat conducting adhesive. The auxiliary heat conductor 360 is connected to the other end 332 that is of the heat conductor 330 and that is exposed out of the packaging member 323, and the auxiliary heat conductor 360 extends in the direction parallel to the liquid cooling plate 341.

In this way, when the power component 320 operates, the heat generated by the other end 3222 that is of the pin 322 and that is exposed out of the packaging member 323 is first transferred to the one end 3221 that is of the pin 322 and that is located in the packaging member 323, and then simultaneously transferred, via the heat conductor 330 that is in heat-conducting connection to the one end 3221 of the pin 322 and the auxiliary heat conductor 360 that is in heat-conducting connection to the heat conductor 330, to the heat conducting adhesive accommodated in the potting groove 343. This increases a heat-conducting contact area between the heat conductor 330 and the heat conducting adhesive. Further, the heat dissipation process of the cooling medium in the liquid cooling plate 341 for the pin 322 is accelerated, thereby improving the overall heat dissipation effect of the power module 300.

In some embodiments, still refer to FIG. 6. In the direction in which the circuit board 310 and the power component body 321 are arranged, the projection of the enclosure plate 342 does not overlap the projection of the packaging member 323, the projection of the heat conductor 330, or projection of the auxiliary heat conductor 360. In other words, in the direction in which the circuit board 310 and the power component body 321 are arranged, the enclosure plate 342 is spaced from and not in contact with the packaging member 323, the enclosure plate 342 is spaced from and not in contact with the heat conductor 330, and the enclosure plate 342 is spaced from and not in contact with the auxiliary heat conductor 360.

This helps avoid a safety problem caused by contact between the enclosure plate 342 and the heat conductor 330, between the enclosure plate 342 and the auxiliary heat conductor 360, and between the enclosure plate 342 and the packaging member 323, improves the safety of the power module 300, and helps meet the safety requirement of the power module 300.

Similarly, in some other embodiments, still refer to FIG. 6. In the direction perpendicular to the direction in which the circuit board 310 and the power component body 321 are arranged, the projection of the liquid cooling plate 341 does not overlap the projection of the packaging member 323, the projection of the heat conductor 330, or projection of the auxiliary heat conductor 360. In other words, in the direction perpendicular to the direction in which the circuit board 310 and the power component body 321 are arranged, the liquid cooling plate 341 is spaced from and not in contact with the packaging member 323, the liquid cooling plate 341 is spaced from and not in contact with the heat conductor 330, and the liquid cooling plate 341 is spaced from and not in contact with the auxiliary heat conductor 360.

This helps avoid a safety problem caused by contact between the liquid cooling plate 341 and the heat conductor 330, between the liquid cooling plate 341 and the packaging member 323, and between the liquid cooling plate 341 and the auxiliary heat conductor 360, improves the safety of the power module 300, and helps meet the safety requirement of the power module 300.

In some embodiments, as shown in FIG. 5, in the direction in which the circuit board 310 and the power component body 321 are arranged, the height d1 of the side that is of the inner side surface 3422 of the enclosure plate 342 and that faces the circuit board 310 is less than the height d2 of the side that is of the outer side surface 3423 of the enclosure plate 342 and that faces the circuit board 310, that is, d1 is less than d2. In this way, the concave part can be formed on the end surface 3421 that is of the enclosure plate 342 and that faces the circuit board 310, and the concave part communicates with the open end of the potting groove 343. For specific descriptions, refer to the embodiments shown in FIG. 3 and FIG. 4. Details are not described herein again.

In an example, as shown in FIG. 5, in the direction perpendicular to the direction in which the circuit board 310 and the power component body 321 are arranged, a distance d5 between the part that is of the inner side surface 3422 and that is located at the open end of the potting groove 343 and the outer surface of the packaging member 323 is greater than or equal to 5 mm, and a distance d6 between the part of the inner side surface 3422 other than the open end of the potting groove 343 and the outer surface of the packaging member 323 is less than 5 mm. In other words, d5 is greater than or equal to 5 mm, and d6 is less than 5 mm, so that the diameter of the open end of the potting groove 343 is large.

This helps avoid voltage breakdown caused by an excessively small distance between the enclosure plate 342 at the open end of the potting groove 343 and the packaging member 323. Further, this can improve the safety of the power module 300, and helps meet the safety requirement of the power module 300.

Further embodiments of the present invention are provided in the following. It should be noted that the numbering used in the following section does not necessarily need to comply with the numbering used in the previous sections.

Embodiment 1. A power module, wherein the power module comprises a circuit board, a power component, a heat conductor, and a liquid cooling component, and the power component is located between the circuit board and the liquid cooling component;
the power component comprises a power component body and a pin, the power component body is fastened to a surface of the circuit board via the pin, the power component body is in heat-conducting connection to the liquid cooling component, and the pin is in heat-conducting connection to the liquid cooling component via the heat conductor; and
the liquid cooling component is configured to exchange heat with the power component body and the heat conductor.

Embodiment 2. The power module according to embodiment 1, wherein the liquid cooling component comprises a liquid cooling plate and an enclosure plate;
the liquid cooling plate is located on a side that is of the power component body and that is away from the circuit board, the enclosure plate is fastened to a surface that is of the liquid cooling plate and that faces the circuit board, the enclosure plate and the liquid cooling plate are enclosed to form a potting groove, the potting groove is configured to accommodate a heat conducting adhesive, and the power component body is buried in the heat conducting adhesive and is in heat-conducting connection to the liquid cooling plate via the heat conducting adhesive; and
one end of the heat conductor is in heat-conducting connection to the pin, and the other end of the heat conductor extends into the heat conducting adhesive and is in heat-conducting connection to the liquid cooling plate via the heat conducting adhesive.

Embodiment 3. The power module according to embodiment 2, wherein the power component further comprises a packaging member, and the packaging member is buried in the heat conducting adhesive and wraps the power component body;
one end of the pin is located in the packaging member and is fastened to the power component body, the other end of the pin extends in a direction of the circuit board and is exposed out of the packaging member, and the other end of the pin is fastened to the circuit board; and
the heat conductor is located outside the packaging member, the one end of the heat conductor is in heat-conducting connection to the other end of the pin, and the other end of the heat conductor extends in a direction of the heat conducting adhesive along an outer surface of the packaging member.

Embodiment 4. The power module according to embodiment 3, wherein the circuit board further comprises a through hole, and the through hole penetrates the circuit board in a direction in which the circuit board and the power component body are arranged; and
the other end of the pin and the one end of the heat conductor pass through the through hole, and the other end of the pin, the one end of the heat conductor, and the through hole are fastened through welding.

Embodiment 5. The power module according to embodiment 2, wherein the power component further comprises a packaging member, and the packaging member is buried in the heat conducting adhesive and wraps the power component body;
one end of the pin is located in the packaging member and is fastened to the power component body, the other end of the pin extends in a direction of the circuit board and is exposed out of the packaging member, and the other end of the pin is fastened to the circuit board; and
the one end of the heat conductor is located in the packaging member and is in heat-conducting connection to the one end of the pin, and the other end of the heat conductor extends in a direction of the liquid cooling plate and is exposed out of the packaging member.

Embodiment 6. The power module according to embodiment 5, wherein the power module further comprises an auxiliary heat conductor, and the auxiliary heat conductor is buried in the heat conducting adhesive; and
the auxiliary heat conductor is in heat-conducting connection to the other end of the heat conductor, and the auxiliary heat conductor extends in a direction parallel to the liquid cooling plate.

Embodiment 7. The power module according to any one of embodiments 3 to 6, wherein in the direction in which the circuit board and the power component body are arranged, a height of an end surface that is of the enclosure plate and that faces the circuit board is less than a height of a surface that is of the packaging member and that faces the circuit board.

Embodiment 8. The power module according to any one of embodiments 3 to 6, wherein in the direction in which the circuit board and the power component body are arranged, projection of the enclosure plate does not overlap projection of the packaging member or projection of the heat conductor; and
in a direction perpendicular to the direction in which the circuit board and the power component body are arranged, projection of the liquid cooling plate does not overlap projection of the packaging member or projection of the heat conductor.

Embodiment 9. The power module according to any one of embodiments 2 to 6, wherein the enclosure plate comprises an inner side surface and an outer side surface that are disposed opposite to each other, and in a direction perpendicular to the direction in which the circuit board and the power component body are arranged, the inner side surface is close to the heat conducting adhesive in the potting groove, and the outer side surface is away from the heat conducting adhesive in the potting groove; and
in the direction in which the circuit board and the power component body are arranged, a height of a side that is of the inner side surface and that faces the circuit board is less than a height of a side that is of the outer side surface and that faces the circuit board.

Embodiment 10. A charging device, wherein the charging device comprises a power module and at least one charging interface;
the power module is electrically connected to the at least one charging interface, the at least one charging interface is configured to electrically connect to an electric vehicle, and the power module is configured to output power to the electric vehicle through the at least one charging interface;
the power module comprises a circuit board, a power component, a heat conductor, and a liquid cooling component, and the power component is located between the circuit board and the liquid cooling component;
the power component comprises a power component body and a pin, the power component body is fastened to a surface of the circuit board via the pin, the power component body is in heat-conducting connection to the liquid cooling component, and the pin is in heat-conducting connection to the liquid cooling component via the heat conductor; and
the liquid cooling component is configured to exchange heat with the power component body and the heat conductor.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A power module, wherein the power module comprises a circuit board, a power component, a heat conductor, and a liquid cooling component, and the power component is located between the circuit board and the liquid cooling component;
the power component comprises a power component body and a pin, the power component body is fastened to a surface of the circuit board via the pin, the power component body is in heat-conducting connection to the liquid cooling component, and the pin is in heat-conducting connection to the liquid cooling component via the heat conductor, wherein the heat conductor comprises a metal copper strip or a metal aluminum strip; and
the liquid cooling component is configured to exchange heat with the power component body and the heat conductor.

2. The power module according to claim 1, wherein the liquid cooling component comprises a liquid cooling plate and an enclosure plate;
the liquid cooling plate is located on a side that is of the power component body and that is away from the circuit board, the enclosure plate is fastened to a surface that is of the liquid cooling plate and that faces the circuit board, the enclosure plate and the liquid cooling plate are enclosed to form a potting groove, the potting groove is configured to accommodate a heat conducting adhesive, and the power component body is buried in the heat conducting adhesive and is in heat-conducting connection to the liquid cooling plate via the heat conducting adhesive; and
one end of the heat conductor is in heat-conducting connection to the pin, and the other end of the heat conductor extends into the heat conducting adhesive and is in heat-conducting connection to the liquid cooling plate via the heat conducting adhesive.

3. The power module according to claim 2, wherein the power component further comprises a packaging member, and the packaging member is buried in the heat conducting adhesive and wraps the power component body;
one end of the pin is located in the packaging member and is fastened to the power component body, the other end of the pin extends in a direction of the circuit board and is exposed out of the packaging member, and the other end of the pin is fastened to the circuit board; and
the heat conductor is located outside the packaging member, the one end of the heat conductor is in heat-conducting connection to the other end of the pin, and the other end of the heat conductor extends in a direction of the heat conducting adhesive along an outer surface of the packaging member.

4. The power module according to claim 3, wherein the circuit board further comprises a through hole, and the through hole penetrates the circuit board in a direction in which the circuit board and the power component body are arranged; and
the other end of the pin and the one end of the heat conductor pass through the through hole, and the other end of the pin, the one end of the heat conductor, and the through hole are fastened through welding.

5. The power module according to claim 2, wherein the power component further comprises a packaging member, and the packaging member is buried in the heat conducting adhesive and wraps the power component body;
one end of the pin is located in the packaging member and is fastened to the power component body, the other end of the pin extends in a direction of the circuit board and is exposed out of the packaging member, and the other end of the pin is fastened to the circuit board; and
the one end of the heat conductor is located in the packaging member and is in heat-conducting connection to the one end of the pin, and the other end of the heat conductor extends in a direction of the liquid cooling plate and is exposed out of the packaging member.

6. The power module according to claim 5, wherein the power module further comprises an auxiliary heat conductor, and the auxiliary heat conductor is buried in the heat conducting adhesive; and
the auxiliary heat conductor is in heat-conducting connection to the other end of the heat conductor, and the auxiliary heat conductor extends in a direction parallel to the liquid cooling plate.

7. The power module according to any one of claims 3 to 6, wherein in the direction in which the circuit board and the power component body are arranged, a height of an end surface that is of the enclosure plate and that faces the circuit board is less than a height of a surface that is of the packaging member and that faces the circuit board.

8. The power module according to any one of claims 3 to 6, wherein in the direction in which the circuit board and the power component body are arranged, projection of the enclosure plate does not overlap projection of the packaging member or projection of the heat conductor; and
in a direction perpendicular to the direction in which the circuit board and the power component body are arranged, projection of the liquid cooling plate does not overlap projection of the packaging member or projection of the heat conductor.

9. The power module according to any one of claims 2 to 6, wherein the enclosure plate comprises an inner side surface and an outer side surface that are disposed opposite to each other, and in a direction perpendicular to the direction in which the circuit board and the power component body are arranged, the inner side surface is close to the heat conducting adhesive in the potting groove, and the outer side surface is away from the heat conducting adhesive in the potting groove; and
in the direction in which the circuit board and the power component body are arranged, a height of a side that is of the inner side surface and that faces the circuit board is less than a height of a side that is of the outer side surface and that faces the circuit board.

10. A charging device, wherein the charging device comprises a power module and at least one charging interface; the power module is electrically connected to the at least one charging interface, the at least one charging interface is configured to electrically connect to an electric vehicle, and the power module is configured to output power to the electric vehicle through the at least one charging interface;
the power module comprises a circuit board, a power component, a heat conductor, and a liquid cooling component, and the power component is located between the circuit board and the liquid cooling component;
the power component comprises a power component body and a pin, the power component body is fastened to a surface of the circuit board via the pin, the power component body is in heat-conducting connection to the liquid cooling component, and the pin is in heat-conducting connection to the liquid cooling component via the heat conductor; and
the liquid cooling component is configured to exchange heat with the power component body and the heat conductor.
